# FASCICULE DE BREVET EUROPEEN

(11) **EP 0 638 933 B1**
(45) Date de publication et mention de la délivrance du brevet: **29.09.1999**
(21) Numéro de dépôt: 94401817.5
(22) Date de dépôt: 05.08.1994
(51) Int. Cl.: H01L 25/065, H01L 21/50

(54) **Procédé d'interconnexion de pastilles semi-conductrices en trois dimensions, et composant en résultant**
Verfahren, um gestapelte Halbleiterchips zusammenzuschalten und Bauelement
Interconnection process of stacked semi-conductors chips and devices

(30) Priorité: 13.08.1993 FR 9309964
(43) Date de publication de la demande: 15.02.1995
(73) Titulaire: THOMSON-CSF, 75008 Paris (FR)
(72) Inventeur: Val, Christian, F-92402 Courbevoie Cédex (FR)
(74) Mandataire: Benoit, Monique

(56) Documents cités:
- EP-A- 0 354 708
- EP-A- 0 565 391
- US-A- 3 239 719
- US-A- 3 746 934
- US-A- 4 525 921
- US-A- 4 868 712
- IBM TECHNICAL DISCLOSURE BULLETIN, vol.17, no.3, Août 1974, NEW YORK US pages 655 - 656 B. AIMI

## Description

La présente invention a pour objet un procédé d'interconnexion de pastilles semi-conductrices en trois dimensions, ainsi que le composant électronique en résultant, chacune des pastilles contenant, par exemple, un composant électronique, un circuit intégré, ou un capteur, l'ensemble pouvant constituer par exemple une micromachine.

La réalisation des systèmes électroniques actuels, tant civils que militaires, doit tenir compte d'exigences de plus en plus grandes de compacité, du fait du nombre de plus en plus élevé de circuits mis en oeuvre.

En ce sens, il a déjà été proposé de réaliser des empilements de circuits intégrés dits "trois dimensions" (3D), comme par exemple décrit dans la demande de brevet français n° 2.670.323 au nom de THOMSON-CSF. Selon cette réalisation, les pastilles semi-conductrices sont empilées après avoir été munies de fils de connexion orientés vers les faces latérales de l'empilement, puis elles sont rendues solidaires les unes des autres par enrobage, par exemple dans une résine; les interconnexions des pastilles sont ensuite réalisées sur les faces de l'empilement.

La présente invention a pour but de modifier ce processus pour permettre au composant 3D résultant de répondre à des spécifications plus strictes en environnement sévère, spatial par exemple. Cela est réalisé notamment en évitant que les pastilles semi-conductrices ne se trouvent finalement.enrobées dans une résine, ce qui permet, d'une part, de meilleures performances à haute fréquence et, d'autre part, de réduire les contraintes mécaniques s'exerçant sur les pastilles lors de variations de température.

Plus précisément, l'invention a pour objet un procédé d'interconnexion de pastilles en trois dimensions tel que décrit par la revendication 1.

Elle a également pour objet un composant en résultant, tel que décrit par la revendication 11.

D'autres objets, particularités et résultats de l'invention ressortiront de la description suivante, donnée à titre d'exemple et illustrée par les dessins annexés, qui représentent:
- la figure 1, un mode de réalisation du procédé selon l'invention ;
- la figure 2a, une vue en perspective éclatée d'un mode de réalisation des premières étapes du procédé selon l'invention ;
- la figure 2b, une vue en coupe partielle de la figure 2a ;
- les figures 3, 4, 5a et 5b, différents modes de réalisation de la première étape du procédé selon l'invention ;
- la figure 6, une vue en coupe de l'empilement obtenu à partir de l'un des modes de réalisation précédents ;
- la figure 7, l'empilement obtenu après découpe de ses faces ;
- les figures 8a et 8b, deux variantes de l'empilement obtenu après élimination du matériau d'enrobage ;
- la figure 8c, une variante de la figure précédente.

Sur ces différentes figures, les mêmes références se rapportent aux mêmes éléments. Par ailleurs, pour la clarté des dessins, l'échelle réelle n'a pas été respectée. Egalement, pour simplifier, on a décrit ci-après le cas où les plaquettes empilées ne contenaient chacune qu'une seule pastille semiconductrice, mais l'invention est bien entendu applicable au cas où les plaquettes, ou substrats, contiennent plusieurs pastilles.

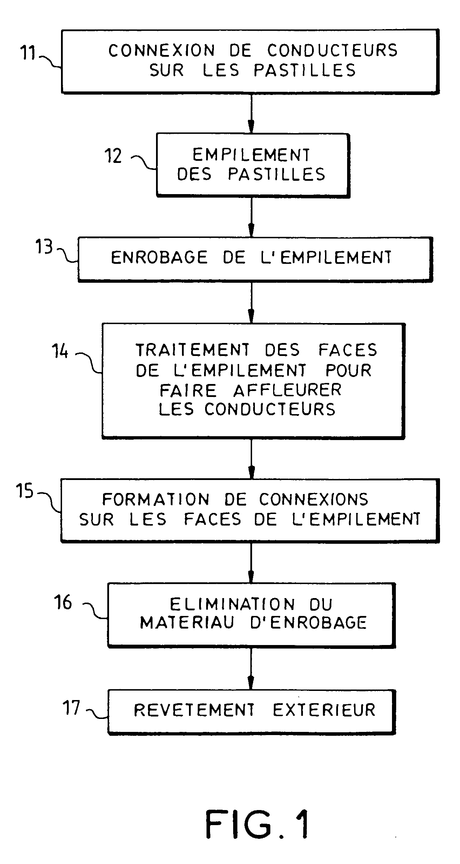

La figure 1 illustre donc un exemple de réalisation du procédé selon l'invention.

La première étape, repérée 11, consiste à connecter électriquement des conducteurs sur chacun des plots des pastilles semi-conductrices destinées à constituer l'empilement.

Cette étape peut être réalisée de différentes manières.

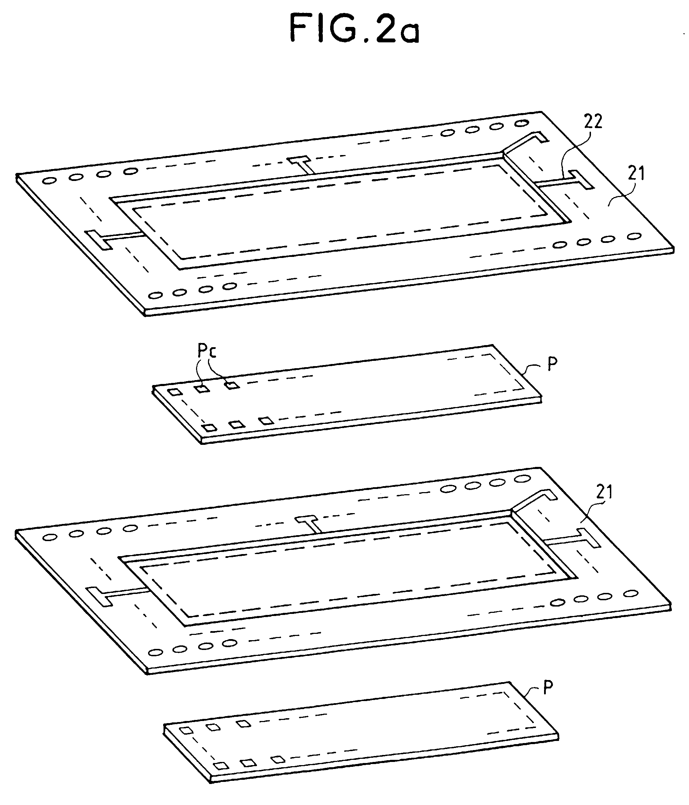

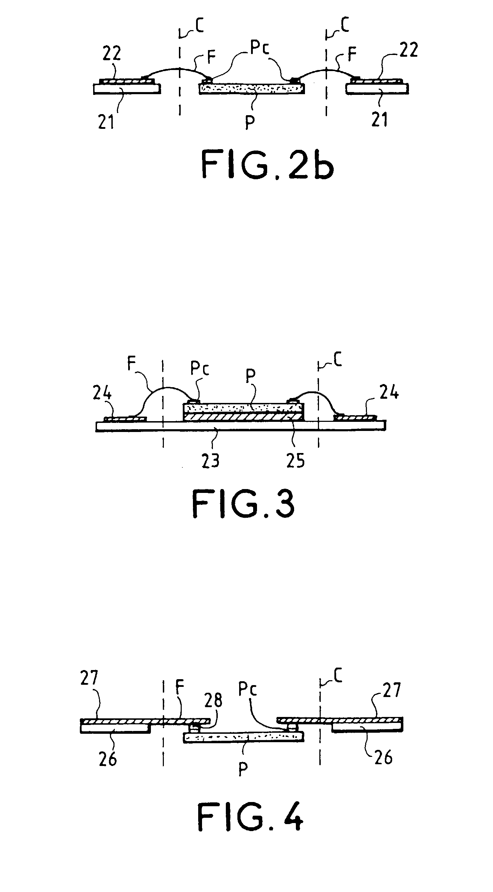

Un premier mode de réalisation est représenté sur les figures 2a et 2b, la figure 2a étant une vue en perspective éclatée de plusieurs pastilles, par exemple deux, et de leurs moyens de connexion, la figure 2b étant une vue en coupe d'une seule pastille et de ses moyens de connexion.

Sur la figure 2a, on a donc représenté deux pastilles, repérées P. Dans chacune de ces pastilles est par exemple réalisé un circuit intégré quelconque, une mémoire par exemple. A la surface de la pastille P apparaissent des plots P_{c} disposés par exemple comme représenté sur la figure, au voisinage de deux des bords de la pastille, ou encore sur l'ensemble de la surface de l'une des faces de la pastille; ces plots P_{c} permettent la connexion électrique du circuit contenu dans la pastille vers l'extérieur.

Les moyens de connexion de chacune des pastilles comprennent: un substrat ou film électriquement isolant 21 en forme de cadre, la pastille P étant destinée à occuper le centre du cadre; des dépôts conducteurs, ou pistes, 22 disposés sur le substrat 21, et enfin des conducteurs électriques F, tels que des fils ou des rubans, câblés entre les plots P_{c} de la pastille et les pistes 22 du substrat 21.

La figure 3 représente, également vu en coupe, un autre mode de réalisation des moyens de connexion d'une pastille P.

Selon cette réalisation, on dispose également d'un substrat électriquement isolant, repéré 23, en forme non plus de cadre mais de plaque, sur laquelle est disposée la pastille P, éventuellement par l'intermédiaire d'une couche conductrice 25.

Comme précédemment, le substrat 23 porte des conducteurs, ou pistes, métallisés 24, et chacun des plots P_{c} de la pastille P est relié à une piste 24 à l'aide d'un conducteur F, fil par exemple.

La figure 4 représente encore un autre mode de réalisation des moyens de connexion des plots des pastilles semi-conductrices.

Sur cette figure, on retrouve une pastille P avec ses plots P_{c}. La connexion est ici réalisée selon une technique connue sous le nom de TAB (pour Tape Automatic Bonding ou connexion automatique par bande); selon cette technique, la pastille P est entourée par un film électriquement isolant 26 en forme de cadre, le film 26 portant des rubans électriquement conducteurs 27, relativement rigides et débordant du cadre 26 de sorte à venir jusqu'au droit des plots P_{c}, la partie des rubans 27 se prolongeant au delà du cadre 26 jouant le rôle des conducteurs F précédents. Les plots P_{c} sont renforcés par une couche conductrice supplémentaire 28 pour former un bossage, et l'ensemble des bossages sont connectés aux rubans 27 en une ou plusieurs opérations.

Dans les différentes variantes illustrées sur les figures 2a à 4, les substrats isolants (21, 23, 26) portant les conducteurs F sont par exemple en un matériau organique.

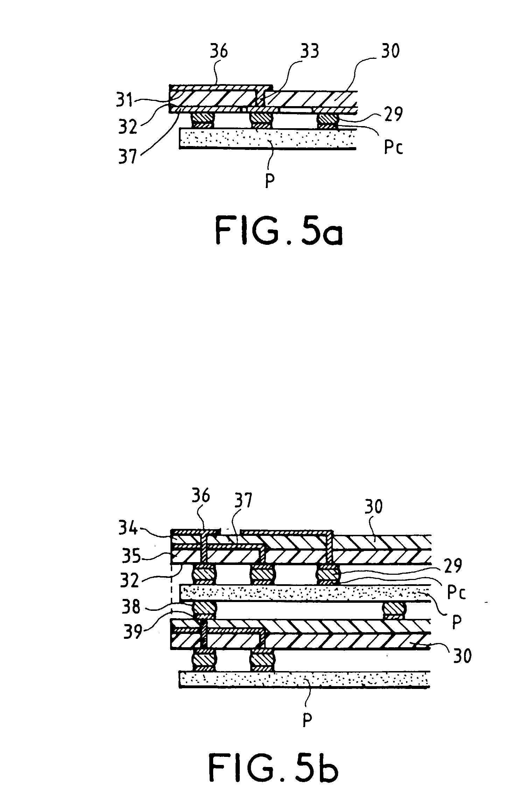

La figure 5a illustre un autre mode de réalisation de la connexion des conducteurs sur les plots des pastilles P.

Sur cette figure, on a représenté en coupe une pastille P portant des plots P_{c}, répartis par exemple sur toute la surface supérieure de la pastille. Chacun des plots P_{c} est recouvert d'une surépaisseur de matériau conducteur 29 pour former un bossage. Les moyens de connexion de cette pastille P sont constitués ici par un support électriquement isolant 30, par exemple en céramique (alumine, nitrure d'aluminium ou diamant par exemple), qui porte des conducteurs sous forme de dépôts métalliques 36 et 37 sur les surfaces inférieure 32 et supérieure 31 du support 30, ces deux surfaces communiquant par exemple par l'intermédiaire de trous métallisés 33, réalisés à travers l'épaisseur du support 30. Les conducteurs 36 et 37 sont connectés aux bossages 29 et relient ainsi les plots P_{c} à la périphérie du support 30.

Dans ce mode de réalisation, ce sont les pistes 36 et 37 qui jouent le rôle des conducteurs F précédents. Pour simplifier, on désignera ci-après par "conducteurs", indistinctement les conducteurs F ou les pistes 36, 37.

L'étape suivante (12) du procédé selon l'invention consiste à empiler les pastilles, munies de leurs moyens de connexion, les unes au-dessus des autres. En tant que besoin, des entretoises ou cales sont ajoutées à l'empilement, entre les pastilles.

La figure 5b représente par exemple un empilement de deux pastilles P et de leurs moyens de connexion dans le cas où ceux-ci sont réalisés comme illustré sur la figure 5a.

Sur la figure 5b, on retrouve donc deux pastilles P portant chacune sur leur face supérieure des plots P_{c} reliés aux pistes portées par un support 30, par l'intermédiaire de bossages 29. A titre d'exemple, le support 30 peut être multicouche, ici constitué de deux couches 34 et 35, de sorte à faciliter le routage des connexions, les conducteurs 36 et 37 étant situés respectivement sur la surface supérieure et sur la surface intermédiaire du support 30, laissant ainsi la face inférieure 32 libre de toute piste.

A titre d'exemple également, la face inférieure de la pastille P, celle qui ne porte pas les plots P_{c}, est également munie de bossages métalliques 38 ; ceux-ci sont destinés à venir en vis-à-vis de plots métalliques 39 portés par le support 30 de la pastille du dessous, cet ensemble étant destiné à faciliter le centrage des pastilles et des supports: en effet, ainsi qu'il est connu, lorsque les éléments 38 et 39 sont amenés à leur point de fusion, les forces de tension superficielle qui y sont créées provoquent leur alignement automatique (autocentrage).

L'avantage de cette variante est, outre les possibilités d'autocentrage, la densité élevée des plots qu'elle permet sur la pastille.

L'étape suivante (13, figure 1) consiste à enrober l'empilement précédemment obtenu à l'aide d'un matériau qui soit susceptible d'être ultérieurement et sélectivement éliminé.

Un tel matériau peut être un matériau organique, tel qu'une résine, résine photosensible par exemple. En tant que besoin, le matériau d'enrobage peut être polymérisé afin de lui donner un minimum de tenue mécanique, sous réserve que cette polymérisation n'interdise pas son élimination ultérieure.

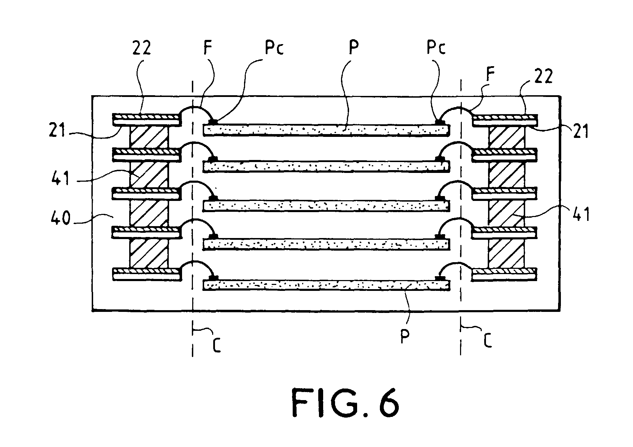

La figure 6 illustre le résultat d'une telle opération, dans le cas par exemple où l'étape 11 a été réalisée comme illustré sur les figures 2a et 2b.

Sur la figure 6, on a représenté un empilement de cinq pastilles P par exemple, chacune étant entourée d'un cadre isolant 21 portant les pistes 22, auxquelles sont connectés les plots P_{c} des pastilles P par l'intermédiaire des fils F. Dans cet exemple, des cales ou entretoises 41 sont disposées entre les cadres 21. L'ensemble est enrobé et noyé dans un matériau 40, tel qu'une résine, qui, bien que vu en coupe, n'a pas été hachuré pour la clarté du schéma. Dans une variante de réalisation, les cales 41 peuvent être disposées entre les pastilles P elles-mêmes, subsistant ainsi dans l'empilement final. Cette variante peut être avantageuse pour rigidifier mécaniquement l'empilement final et/ou contribuer à son adaptation thermique.

L'étape suivante (14, figure 1) consiste à traiter les faces de l'empilement, par découpe ou polissage suivant le mode de réalisation, afin de faire apparaître sur les faces latérales de l'empilement la section des conducteurs (conducteurs F ou pistes 36-37) qui sont connectés aux plots P_{c} des pastilles P.

Dans le mode de réalisation illustré sur les figures 2b, 3, 4 ou 6, ce traitement consiste à effectuer une découpe selon le pointillé C, c'est-à-dire au niveau des conducteurs F entre les plots P_{c} des pastilles P et les pistes auxquelles ces conducteurs sont connectés à leur autre extrémité. On voit plus particulièrement sur la figure 6 que la découpe a pour effet de supprimer les entretoises 41 et les cadres 21, ne laissant subsister dans l'empilement aucun autre matériau organique que le matériau d'enrobage 40, ultérieurement éliminé. Ceci est vrai pour les modes de réalisation des figures 2 et 4.

Dans le mode de réalisation illustré sur les figures 5a ou 5b, ce traitement de l'étape 14 peut consister soit comme précédemment en une découpe, soit en un simple polissage, de sorte à faire apparaître la section des pistes 36 et 37.

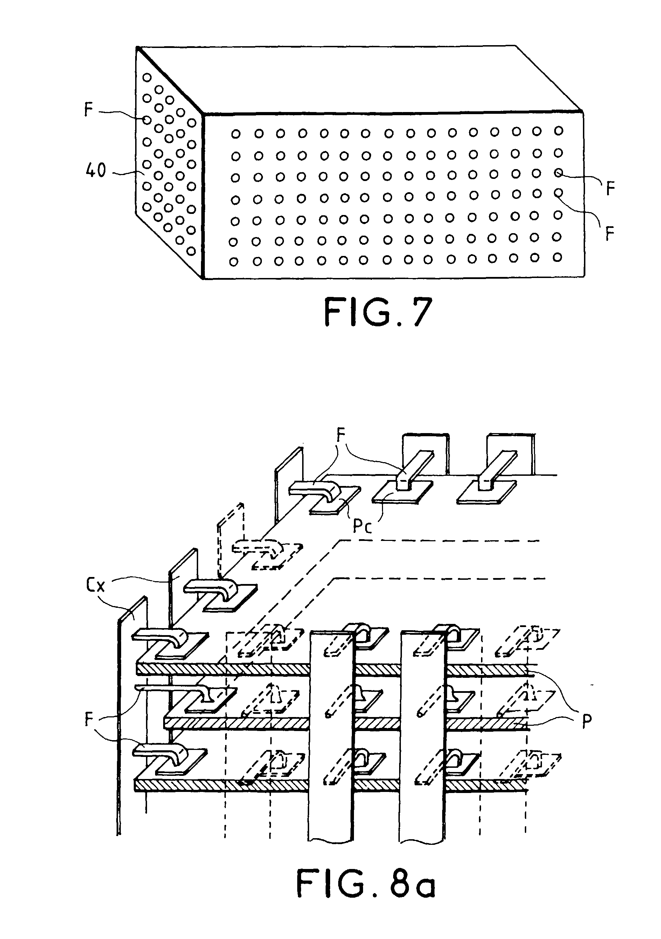

Le résultat de cette opération est illustré sur la figure 7.

L'empilement obtenu après découpe est par exemple de forme parallélépipédique rectangle comme représenté sur la figure, mais il peut également être en forme de parallélépipède non rectangle, de cylindre droit ou oblique, ou toute autre forme. Les surfaces extérieures de l'empilement sont constituées par le matériau d'enrobage 40, au milieu duquel affleurent les sections des conducteurs (F, 36, 37), représentées par exemple circulaires dans le cas de fils mais qui peuvent affecter toute autre forme, rectangulaire par exemple dans le cas de rubans.

L'étape d'après (15, figure 1) consiste à réaliser, sur les surfaces extérieures de l'empilement, des connexions reliant électriquement les sections des conducteurs (F, 36, 37).

Ces connexions peuvent être réalisées de diverses manières: par exemple, par dépôt d'une couche conductrice, métallique par exemple, par tous moyens connus (dépôt chimique, électrochimique, dépôt sous vide...), puis gravure de cette couche pour réaliser les connexions, à l'aide d'un laser comme par exemple décrit dans la demande de brevet précitée, ou encore par photogravure. Elles peuvent être également réalisées par dépôt direct de pistes conductrices, par sérigraphie ou à l'aide d'un laser; selon cette dernière technique, on trempe l'empilement dans un matériau organo-métallique puis on l'élimine sauf sur les parties éclairées à l'aide d'un laser, selon le dessin voulu pour les connexions: ainsi qu'il est connu, le laser, en modifiant les liaisons chimiques entre les constituants du matériau organo-métallique, permet au métal d'adhérer à l'empilement; on peut ainsi déposer par exemple du palladium ou du cuivre ; au cas où les épaisseurs obtenues sont insuffisantes, il est possible de les augmenter par recharge, selon toute technique connue.

Dans une variante de réalisation, les étapes 14 et/ou 15 sont réalisées de telle sorte que les conducteurs (F, 36, 37) non pas affleurent mais fassent saillie par rapport à la surface latérale de l'empilement. Ceci peut être réalisé par exemple par formation de cuvettes dans la surface latérale, autour desdits conducteurs, ou encore de rainures réunissant plusieurs conducteurs, par exemple à l'aide d'un laser ou comme décrit ci-après. Cette variante permet de faciliter les connexions de l'étape 15 et/ou d'en améliorer la qualité. A titre d'exemple, pour renforcer le contact électrique entre les connexions de l'étape 15 et la section des conducteurs (F, 36, 37) dans le cas où le matériau d'enrobage est une résine photosensible, on forme des rainures de la façon suivante. Après l'étape 14, les conducteurs affleurent les faces latérales de l'empilement. On insole alors la résine photosensible selon le dessin désiré pour les connexions, la résine étant choisie de façon appropriée pour que seule la partie insolée soit attaquée lors d'une phase ultérieure de dissolution: on obtient de la sorte une légère rainure (qui peut être typiquement de l'ordre de la dizaine de micromètres) selon le dessin des connexions, dégageant l'extrémité des conducteurs. Les connexions réalisées ensuite pourront adhérer sur toute l'extrémité des conducteurs, et non seulement sur leur section.

L'étape suivante (16, figure 1) consiste à éliminer sélectivement le matériau d'enrobage 40.

Ceci s'effectue à l'aide de solvants spécifiques, liquides ou gazeux. A titre d'exemple, on peut utiliser de l'acétone ou un plasma d'oxygène pour éliminer une résine photosensible.

La figure 8a est une vue en perspective fractionnaire de l'empilement après élimination du matériau d'enrobage, toujours à titre d'exemple dans le cas du mode de réalisation illustré sur les figures 2a et 2b.

Sur la figure 8a, on voit donc trois pastilles P et quelques uns de leurs plots P_{c} auxquels sont connectés des conducteurs F; à titre illustratif, on a représenté sur le même schéma des conducteurs F sous forme de fils et de rubans, étant entendu qu'en général, on réalise un empilement avec des fils uniquement ou des rubans uniquement. Les conducteurs F sont reliés entre eux par des connexions verticales Cₓ, en forme de rubans de plus grande largeur par exemple.

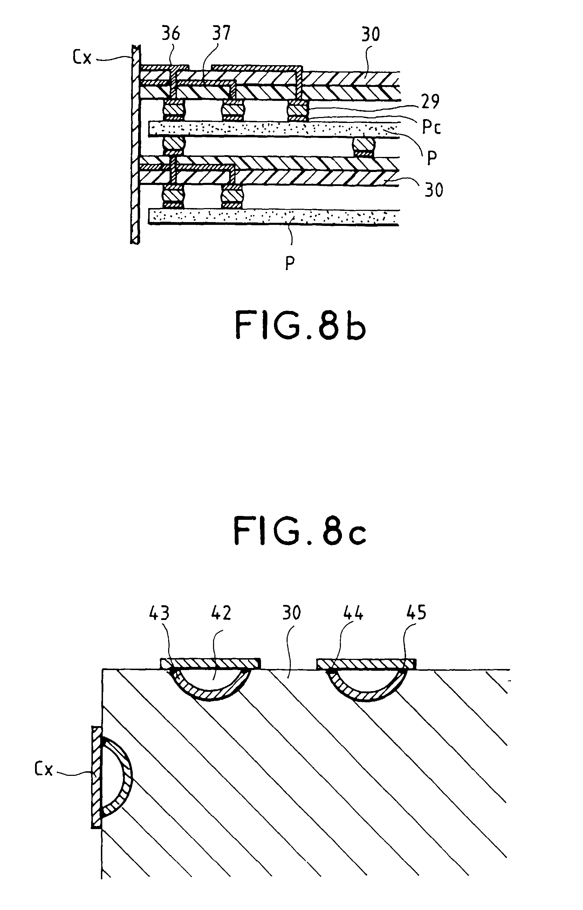

La figure 8b est analogue à la figure 8a, mais pour le mode de réalisation des figures 5a ou 5b.

Les pistes 36 et/ou 37 sont reliées entre elles par une connexion verticale Cₓ, qui s'appuie en outre sur les substrats isolants 30.

Dans une variante de réalisation, illustrée sur la figure 8c, qui est une vue en coupe d'un support 30 dans un plan parallèle au support, lorsqu'on désire réaliser des connexions verticales entre les conducteurs ou pistes 36, 37, on peut munir les supports isolants 30 de demi-trous 42, aussi appelés castellations, métallisés (43) et alignés.

Le contact électrique s'effectuera avec la connexion verticale Cₓ selon les deux bords 44 et 45 de la métallisation 43, permettant ainsi un meilleur contact électrique par suite de l'accroissement des aires des sections en contact.

De la sorte, on obtient un empilement dans lequel le matériau d'enrobage a été éliminé et, dans ces modes de réalisation particuliers, exempt de tout matériau organique, les pastilles étant ici portées mécaniquement par leurs connexions électriques (F, 36, 37,Cₓ) et, le cas échéant, les substrats (3) portant ces connexions, avec l'aide éventuellement d'entretoises (41).

Selon une variante, le procédé selon l'invention peut comporter une étape supplémentaire (17, figure 1) lors de laquelle l'empilement précédemment obtenu est revêtu extérieurement d'une couche électriquement isolante, de préférence minérale, oxyde de silicium par exemple, dont les fonctions sont principalement d'éviter la corrosion et de renforcer la tenue mécanique de l'ensemble. Cette couche isolante peut être déposée par exemple par voie chimique, en phase gazeuse activée par plasma; cette technique est connue sous le nom de PECVD (pour Plasma Enhanced Chemical Vapor Deposition ou dépôt par vapeur chimique activée par plasma) et elle présente l'avantage de pouvoir être réalisée à basse température (100 à 150°c, typiquement).

On a ainsi décrit un composant résultant de l'empilement en trois dimensions de pastilles semi-conductrices, solidaires mécaniquement les unes des autres mais ne comportant pas de matériau d'enrobage ou d'adhésif organique. Cette caractéristique permet d'inclure dans l'empilement des plaquettes portant des micro-moteurs ou capteurs comportant des pièces mobiles. Un autre avantage en est une meilleure tenue mécanique lors de variations de température : en effet, les coefficients de dilatation thermique des matériaux semi-conducteurs et des matériaux organiques d'enrobage sont en général très différents, engendrant des contraintes pouvant aller jusqu'à la rupture des pastilles semi-conductrices. Le composant selon l'invention peut donc être utilisé dans des environnements requièrant une grande fiabilité et/ou soumis à d'importantes variations de température. En outre, les différents conducteurs étant, selon l'invention, entourés d'air et non de matériau d'enrobage, les valeurs des capacités parasites entre conducteurs, fonctions de la valeur de la constante diélectrique (ε) du milieu situé entre les conducteurs (typiquement ε=4 pour la résine époxy, alors que ε=1 pour l'air), sont beaucoup plus faibles, autorisant ainsi le fonctionnement des composants à beaucoup plus haute fréquence. Enfin, bien entendu, le composant 3D sans matériau d'enrobage ni, le cas échéant, pièces support, voit sa masse réduite par rapport à un composant du même type qui en comporterait.

## Revendications

1. Procédé d'interconnexion de plaquettes en trois dimensions, les plaquettes comportant une ou plusieurs pastilles semi-conductrices, les pastilles comportant des plots pour leur interconnexion, le procédé étant caractérisé par le fait qu'il comporte successivement les étapes suivantes :
• connexion (11) de conducteurs (F, 36, 37) aux plots (P_{c}) des plaquettes ;
• empilement (12) des plaquettes (P) ;
• enrobage (13) de l'empilement à l'aide d'un matériau (40) sélectivement éliminable ;
• traitement(14) des faces latérales de l'empilement pour faire affleurer les conducteurs sur les faces latérales:
• formation (15) sur les faces latérales de l'empilement de connexions (Cₓ) pour l'interconnexion des conducteurs ;
• élimination (16) du matériau d'enrobage.

2. Procédé selon la revendication 1, caractérisé par le fait que, lors de la première étape (11), chacune des plaquettes (P) est disposée à l'intérieur d'un cadre (21) en matériau électriquement isolant, portant des dépôts conducteurs (22) ; que les conducteurs (F) sont connectés entre les plots (P_{c}) et les dépôts conducteurs, et que, lors de la quatrième étape (14), les faces latérales de l'empilement sont traitées de sorte à supprimer le cadre.

3. Procédé selon la revendication 1, caractérisé par le fait que, lors de la première étape (11), chacune des plaquettes (P) est disposée sur une plaque (23) en matériau électriquement isolant, la plaque portant des dépôts conducteurs (24), et que les conducteurs (F) sont connectés entre les plots (P_{c}) et les dépôts conducteurs.

4. Procédé selon la revendication 1, caractérisé par le fait que, lors de la première étape, chacune des plaquettes (P) est disposée à l'intérieur d'un cadre (26) en matériau électriquement isolant, le cadre portant des rubans conducteurs (27) se prolongeant (F) au delà du cadre de sorte à venir au dessus des plots (P_{c}) et étant connectés à ces derniers, et que, lors de la quatrième étape (14), les faces latérales de l'empilement sont traitées de sorte à supprimer le cadre.

5. Procédé selon la revendication 1, caractérisé par le fait que, lors de la première étape, les plots (P_{c}) de chacune des plaquettes sont recouverts de bossages (29), qu'un substrat (30) électriquement isolant est disposé au-dessus de la face de la plaquette qui porte les plots, que le substrat porte des dépôts métalliques (36, 37) sur ses faces supérieure et inférieure, reliés aux bossages, et que, lors de la quatrième étape (14), les faces latérales de l'empilement sont traitées de sorte à faire affleurer les dépôts métalliques.

6. Procédé selon la revendication 5, caractérisé par le fait que chacune des plaquettes (P) comporte en outre une deuxième série de bossages (38) réalisés sur celle de ses faces qui ne porte pas de plots (P_{c}), et que le substrat (30) affecté à la plaquette voisine dans l'empilement porte des plots (39) destinés à être connectés aux bossages de la deuxième série.

7. Procédé selon l'une des revendications 5 ou 6, caractérisé par le fait que les substrats (30) comportent chacun des demi-trous métallisés (42, 43) réalisés sur leurs faces latérales, au niveau où sont réalisées les connexions (Cₓ) de l'empilement et destinés à être en contact avec celles-ci.

8. Procédé selon la revendication 1, caractérisé par le fait que, lors de la cinquième étape, il est formé des rainures dans l'empilement selon-le dessin des connexions (Cₓ), les rainures dégageant l'extrémité des conducteurs.

9. Procédé selon la revendication 1, caractérisé par le fait qu'on dispose des entretoises (41) entre les plaquettes lors de l'empilement.

10. Procédé selon l'une des revendications précédentes, caractérisé par le fait qu'il comporte en outre une étape (17) de revêtement de l'empilement par une couche électriquement isolante d'un matériau minéral.

11. Composant comportant des plaquettes interconnectées, les plaquettes comportant une ou plusieurs pastilles semi-conductrices, les pastilles comportant des plots (P_{c}) pour leur interconnexion, le composant étant caractérisé par le fait qu'il comporte une pluralité de plaquettes (P) empilées, des conducteurs (F, 36, 37) connectés aux plots (P_{c}) des plaquettes et s'étendant jusqu'aux faces latérales de l'empilement jusqu'à affleurer ces faces latérales, et des connexions (C_{X}) directement reliées aux conducteurs, disposées sur les faces latérales de l'empilement, les connexions formant support mécanique pour les plaquettes, le composant ne comportant pas d'enrobage des plaquettes.

## Patentansprüche

1. Dreidimensionales Verdrahtungsverfahren für Plättchen, die einen oder mehrere Halbleiterchips enthalten, wobei diese Chips Anschlußpunkte für die Verdrahtung besitzen, gekennzeichnet durch die folgenden Verfahrensschritte:
• Anschluß (11) von Leitern (F, 36, 37) an die Anschlußpunkte (P_{c}) der Plättchen,
• Stapelung (12) der Plättchen (P),
• Umhüllung (13) des Stapels mit einem selektiv entfernbaren Material (40),
• Behandlung (14) der Seitenflächen des Stapels, um die Leiter an den Seitenflächen zutage treten zu lassen,
• Bildung (15) von Verbindungen (Cₓ) auf den Seitenflächen des Stapels, um die Leiter miteinander zu verdrahten,
• Entfernung (16) des Umhüllungsmaterials.

2. Verfahren nach Anspruch 1, dadurch gekennzeichnet, daß während des ersten Verfahrensschritts (11) jedes der Plättchen (P) in einen Rahmen (21) aus einem elektrisch isolierenden Material angeordnet wird, der leitende Schichten (22) trägt, daß die Leiter (F) zwischen die Anschlußpunkte (P_{c}) und die leitenden Schichten angeschlossen werden und daß während des vierten Verfahrensschritts (14) die Seitenflächen des Stapels so behandelt werden, daß der Rahmen entfernt wird.

3. Verfahren nach Anspruch 1, dadurch gekennzeichnet, daß während des ersten Verfahrensschritts (11) jedes Plättchen (P) auf einer Platte (23) aus elektrisch isolierendem Material angeordnet wird, die leitende Schichten (24) trägt, und daß die Leiter (F) zwischen die Anschlußpunkte (P_{c}) und die leitenden Schichten angeschlossen werden.

4. Verfahren nach Anspruch 1, dadurch gekennzeichnet, daß während des ersten Verfahrensschritts jedes Plättchen (P) in einem Rahmen (26) aus elektrisch isolierendem Material angeordnet wird, der leitende Bänder (27) trägt, die Verlängerungen (F) über den Rahmen hinaus bilden, sodaß sie über Anschlußpunkte (P_{c}) gelangen und an diese angeschlossen werden, und daß während des vierten Verfahrensschritts (14) die Seitenflächen des Stapels so behandelt werden, daß der Rahmen entfällt.

5. Verfahren nach Anspruch 1, dadurch gekennzeichnet, daß während des ersten Verfahrensschritts (11) die Anschlußpunkte (P_{c}) jedes Plättchens mit Erhöhungen (29) versehen werden, daß ein elektrisch isolierender Träger (30) oberhalb derjenigen Oberseite des Plättchens angeordnet wird, die die Anschlußpunkte trägt, daß der Träger Metallbeschichtungen (36, 37) auf seiner Ober- und Unterseite trägt, die an die Erhöhungen angeschlossen werden, und daß während des vierten Verfahrensschritts (14) die Seitenflächen des Stapels so behandelt werden, daß die Metallschichten zutage treten.

6. Verfahren nach Anspruch 5, dadurch gekennzeichnet, daß jedes Plättchen (P) außerdem eine zweite Reihe von Erhöhungen (38) auf derjenigen Seite besitzt, die keine Anschlußpunkte (P_{c}) trägt, und daß der dem benachbarten Plättchen im Stapel zugeordnete Träger (30) Anschlußpunkte (39) trägt, die an die Erhöhungen der zweiten Reihe angeschlossen werden sollen.

7. Verfahren nach einem der Ansprüche 5 und 6, dadurch gekennzeichnet, daß jeder Träger (30) metallbeschichtete Halblöcher (42, 43) an seinen Seiten an der Stelle besitzen, an der die Verbindungen (Cₓ) des Stapels erfolgen, mit denen sie in Kontakt kommen sollen.

8. Verfahren nach Anspruch 1, dadurch gekennzeichnet, daß während des fünften Verfahrensschritts Rinnen im Stapel gemäß dem Muster der Verbindungen (Cₓ) gebildet werden, die die Enden der Leiter freilegen.

9. Verfahren nach Anspruch 1, dadurch gekennzeichnet, daß zwischen die Plättchen während des Stapelns Abstandsstücke (41) eingefügt werden.

10. Verfahren nach einem der vorstehenden Ansprüche, dadurch gekennzeichnet, daß es außerdem einen Verfahrensschritt (17) aufweist, bei dem der Stapel mit einer elektrisch isolierenden Schicht eines anorganischen Materials bedeckt wird.

11. Bauelement aus miteinander verdrahteten Plättchen, die einen oder mehrere Halbleiterchips enthalten, wobei die Chips Anschlußpunkte (P_{c}) für ihre Verdrahtung besitzen, dadurch gekennzeichnet, daß es mehrere gestapelte Plättchen, an die Anschlußpunkte (P_{c}) der PlättchenChips angeschlossene Leiter (F, 36, 37), die sich bis zu den seitlichen Außenflächen des Stapels erstrecken und an diesen seitlichen Außenflächen zutage treten, und Verbindungen (Cₓ) aufweist, die unmittelbar an die Leiter angeschlossen sind und an den seitlichen Außenflächen des Stapels liegen, wobei diese Verbindungen den mechanischen Halt der Plättchen bilden, während das Bauelement keine Umhüllung der Plättchen aufweist.

## Claims

1. Method for interconnecting wafers in three dimensions, the wafers comprising one or more semiconductor chips, the chips comprising pads for their interconnection, the process being characterized by the fact that it comprises the following steps in succession:
• connecting (11) leads (F, 36, 37) to the pads (P_{c}) of the wafers;
• stacking (12) the wafers (P);
• embedding (13) the stack by means of a selectively removable material (40) ;
• treating (14) the lateral faces of the stack in order to make the leads flush with the lateral faces;
• forming (15) connections (Cₓ) on the lateral faces of the stack, for interconnecting the leads;
• removing (16) the embedding material.

2. Method according to Claim 1, characterized by the fact that, during the first step (11), each of the wafers (P) is arranged inside a frame (21) of electrically insulating material, carrying conducting depositions (22); that the leads (F) are connected between the pads (P_{c}) and the conducting depositions, and that, during the fourth step (14), the lateral faces of the stack are treated so as to eliminate the frame.

3. Method according to Claim 1, characterized by the fact that, during the first step (11), each of the wafers (P) is arranged on a plate (23) of electrically insulating material, the plate carrying conducting depositions (24), and chat the leads (F) are connected between the pads (P_{c}) and the conducting depositions.

4. Method according to Claim 1, characterized by the fact that, during the first step, each of the wafers (P) is arranged inside a frame (26) of electrically insulating material, the frame carrying conducting strips (27) extending (F) beyond the frame so as to come above the pads (P_{c}) and being connected to the latter, and that, during the fourth step (14), the lateral faces of the stack are treated so as to eliminate the frame.

5. Method according to Claim 1, characterized by the fact that, during the first step, the pads (P_{c}) of each of the wafers are covered with bumps (29), that an electrically insulating substrate (30) is arranged above the face of the wafer which carries the pads, that the substrate carries metallic depositions (36, 37) on its upper and lower faces, which depositions are linked to the bumps, and that, during the fourth step (14), the lateral faces of the stack are treated so as to make the metallic depositions flush.

6. Method according to Claim 5, characterized by the fact that each of the wafers (P) further comprises a second series of bumps (38) made on that one of its faces which does not carry pads (P_{c}), and that the substrate (30) assigned to the neighbouring wafer within the stack carries pads (39) intended to be connected to the bumps of the second series.

7. Method according to one of Claims 5 or 6, characterized by the fact that the substrates (30) each comprise metallized half-holes (42, 43) made on their lateral faces, where the connections (Cₓ) of the stack are made and intended to be in contact with them.

8. Method according to Claim 1, characterized by the fact that, during the fifth step, grooves are formed in the stack in accordance with the pattern of the connections (Cₓ), the grooves exposing the end of the leads.

9. Method according to Claim 1, characterized by the fact that spacers (41) are arranged between the wafers during stacking.

10. Method according to one of the preceding claims, characterized by the fact that it further comprises a step (17) of coating the stack with an electrically insulating layer of a mineral material.

11. Component comprising interconnected wafers, the wafers comprising one or more semiconductor chips, the chips comprising pads (P_{c}) for their interconnection, the component being characterized by the fact that it comprises a plurality of stacked wafers (P), leads (F, 36, 37) connected to the pads (P_{c}) of the wafers and extending to the lateral faces of the stack until they are flush with these lateral faces, and connections (Cₓ) directly connected to the leads, arranged on the lateral faces of the stack, the connections forming a mechanical support for the wafers, the component comprising no embedding for the wafers.
